# EUROPEAN PATENT APPLICATION

(11) **EP 4 467 512 A1**
(43) Date of publication of application: **27.11.2024**
(21) Application number: 23174731.2
(22) Date of filing: 23.05.2023
(51) Int. Cl.: B81B 7/00

(54) **MEMS COMPONENT WITH UPSIDE-DOWN CHIP**

(71) Applicant: Murata Manufacturing Co., Ltd., Nagaokakyo-shi, Kyoto 617-8555 (JP)
(72) Inventor: NURMI, Sami, 04320 Tuusula (FI); YLÄNEN, Joanna, 02630 Espoo (FI); HURME, Susanna, 01690 Vantaa (FI); HALL, Michael, 01620 Vantaa (FI); SYRJÄNEN, Teppo, 00400 Helsinki (FI); BLOMQVIST, Anssi, 00980 Helsinki (FI); RYTKÖNEN, Ville-Pekka, 01820 Klaukkala (FI)
(74) Representative: Boco IP Oy Ab

(57) **Abstract**

A MEMS component which comprises a MEMS chip and a housing which forms an enclosure around the MEMS chip. The housing comprises a ceramic package structure, and the MEMS component comprises electrical connections which extend from the MEMS chip through the ceramic package structure to an external contact electrode, the ceramic package structure forms the upper unit of the housing and the MEMS chip is mounted to the top of the enclosure.

## Description

### FIELD OF THE DISCLOSURE

The present disclosure relates to microelectromechanical (MEMS) components, and more particularly to MEMS components enclosed in a ceramic package. The present disclosure further concerns the operation of such components under mechanical stress.

### BACKGROUND OF THE DISCLOSURE

MEMS components such as accelerometers and gyroscopes typically comprise a MEMS chip and a package which forms a protective enclosure around the chip. The MEMS chip typically comprises a sealed cavity where the mobile parts of the chip are located. It also comprises electrical chip-level connections which extend from the mobile parts to the outside of the chip. Component-level electrical connections can be drawn from the inside of the package to the outside. When the component is mounted on a circuit board, these component-level connections are connected to the circuit board.

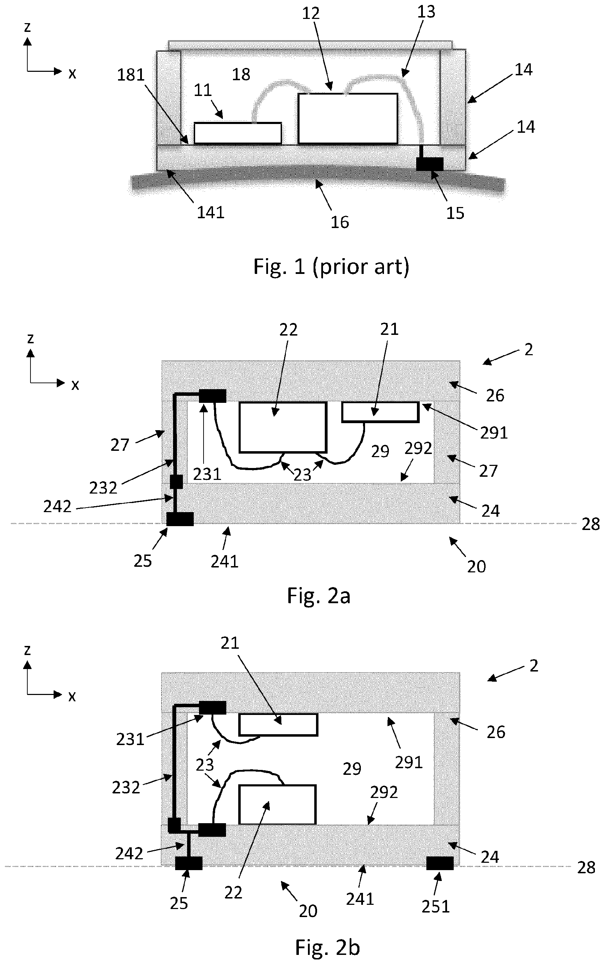

Figure 1 illustrates a MEMS component known from the prior art. The component comprises a MEMS chip 11 and a control chip 12 inside an enclosure 18 formed by a ceramic package structure 14. The component is mounted on a printed circuit board (PCB) 16 so that the bottom surface 141 of the packaging part 14 is attached to the circuit board. The chips (11, 12) are mounted on the floor 181 of the enclosure 18. The component also comprises an electrical connection 13 which extends from the chips to a contact electrode 15 located on the bottom surface 141 of the packaging part 14. The chips are connected to the external circuit on the PCB through the contact electrode 15.

A problem with the component illustrated in figure 1 is that mechanical stress, illustrated by the bent shape of the PCB 16, is easily transmitted from the PCB to the floor 181 of the enclosure and from the floor to the MEMS chip 11. This can severely degrade the performance of the MEMS component since measurements will only be accurate as long as the MEMS chip is oriented correctly.

### BRIEF DESCRIPTION OF THE DISCLOSURE

An object of the present disclosure is to provide an apparatus for overcoming the above problem. The disclosure is based on the idea of mounting the MEMS chip on the ceiling of the enclosure.

### BRIEF DESCRIPTION OF THE DRAWINGS

In the following the disclosure will be described in greater detail by means of preferred embodiments with reference to the accompanying drawings, in which
Figure 1 illustrates a MEMS component known from the prior art.
Figure 2a illustrates a MEMS component with a MEMS chip and a control chip mounted to the top of the enclosure.
Figure 2b illustrates a MEMS component with a MEMS chip mounted to the top of the enclosure and a control chip mounted to the bottom of the enclosure.
Figure 3a illustrates a MEMS component with a metallic or plastic floor structure.
Figures 3b - 3c illustrate MEMS component where electrical connections extend to the sides of the component.

### DETAILED DESCRIPTION OF THE DISCLOSURE

This disclosure describes a MEMS component which comprises a MEMS chip and a housing which forms an enclosure around the MEMS chip. The enclosure has a top and a bottom and the housing has an upper unit, a lower unit and sidewalls which extend between the upper unit and the lower unit. The upper unit of the housing delimits the top of the enclosure, and the lower unit of the housing delimits the bottom of the enclosure.

The lower unit or the sidewalls of the housing form an external bottom surface of the housing. The external bottom surface lies on a contacting side of the component. The housing comprises a ceramic package structure. The MEMS component comprises electrical connections which extend from the MEMS chip through the ceramic package structure to the contacting side of the component. The ceramic package structure forms at least the upper unit of the housing. The MEMS chip is mounted to the top of the enclosure.

The MEMS component may be a gyroscope in any embodiment presented in this disclosure. Alternatively, the MEMS component may be an accelerometer. The component may alternatively be both a gyroscope and an accelerometer: it may comprise multiple MEMS chips, some of which may be gyroscope chips and others accelerometer chips. All MEMS chips may be mounted to the top of the enclosure and connected to external contact electrodes as the figures illustrate.

Figure 2a illustrates a MEMS component 2 with a MEMS chip 21 and a housing which surrounds the chip 21 and forms and enclosure 29 around the chip 21. The housing comprises upper unit 26 and lower unit 24. Figure 2a also illustrates an optional control chip 22 within the housing. The MEMS chip 21 is mounted to the top of the enclosure 29. The control chip 22 may also be mounted to the top 291 of the enclosure 29. In any embodiment of this disclosure, the control chip 22 may be an ASIC (application-specific integrated circuit) chip.

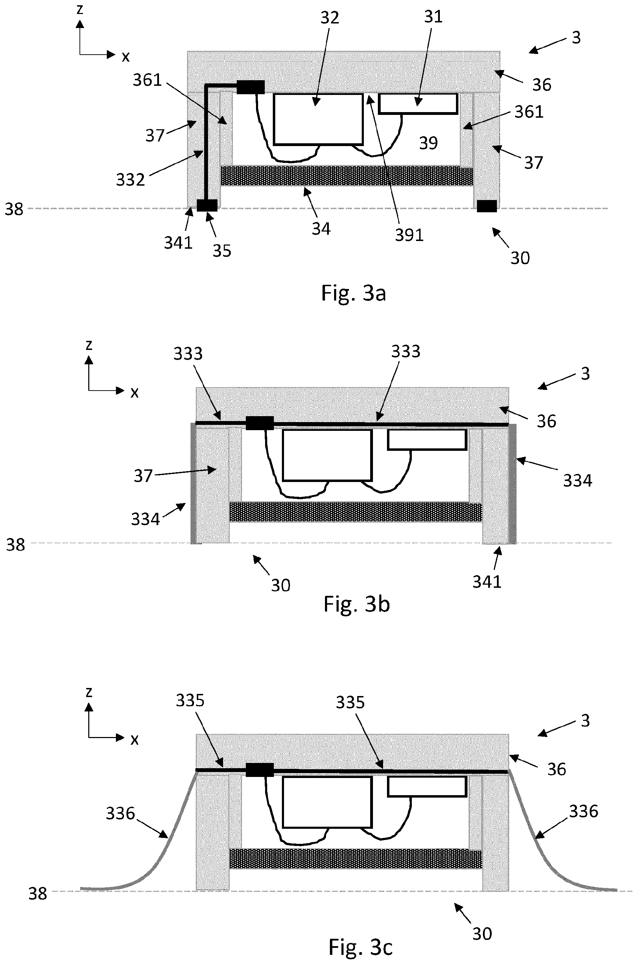

The housing also comprises sidewalls 27 which extend between the upper unit and the lower unit. The sidewalls may be an integral part of the upper unit 26 or an integral part of the lower unit 24. In general, the component 2 is assembled by mounting at least the MEMS chip 21 onto the upper unit 26 and then sealing it inside the housing by attaching the upper unit 26 to the lower unit 24. The sidewalls 27 extend between the upper unit 26 and the lower unit 24 when these units are attached to each other. The sidewalls 27 may also extend past the lower unit 24, as illustrated in figure 3a. The options described in this disclosure apply to all embodiments.

The housing forms the enclosure 29 where the chips are located. The enclosure may alternatively be called a cavity. This enclosure 29 has a top 291 and a bottom 292. The MEMS chip 21 is attached to the top 291 of the enclosure 29. The control chip 22 may also be mounted to the top of the enclosure 29, as figure 2a illustrates. In figures 2a and 2b, the lower unit 24 of the housing has an external bottom surface 241. This surface defines a contacting side 20 of the component. Electrical connections 23, 231 and 232 extend from the MEMS chip to the electrode 25 which lies on the contacting side 20. In this case the connections 23, 231 and 232 extend through the upper unit 26, the sidewalls 27 and the lower unit 24.

The terminology of this disclosure is based on the assumption that the external bottom surface 241 of the housing faces "downward", which is the direction where the intended mounting surface will be located. In other words, when the MEMS component 2 is mounted onto a printed circuit board, the external bottom surface 241 faces the printed circuit board.The external contact electrode 25 is located on the external bottom surface 241, and it facilitates an electrical connection between the chips 21 and 22 and the underlying circuit board. The component may in practice contain multiple contacts on the bottom surface and multiple electrical paths from these contacts to the chips, but only one contact (25) and one path (23+231+232) is illustrated in figure 2a for simplicity.

The term "contacting side" refers in this disclosure to the side of the component where the external contact electrodes 25 of the component can be electrically connected to an underlying circuit board. The contacting side 20 corresponds to the downward side, or bottom of the component, but electrical connections which extend to the contacting side do not necessarily have to be located on the bottom surface. The electrical connections can alternatively be located on the sides of the component. This will be explained below with reference to figures 3b and 3c.

The line 28 in figures 2a - 2b illustrates schematically a surface where the component may be mounted. This surface lies on the contacting side of the component. Since the MEMS chip 21 is mounted on the upper part of the housing, the MEMS chip 21 is not on the contacting side of the component. It is instead on the opposite side of the component, which is the top side.

The terms "upper", "lower", "top" and "bottom", "up" and "down" are used in this disclosure as relative terms which describe the position or orientation of elements in relation to the bottom surface 241. In other words, an "upper" element is further away from the surface 241 than a "lower" element, etc. These terms do not in this disclosure refer to the orientation of the component in relation to the Earth's gravitational field. In other words, the component can be oriented in any direction in relation to this field during both use and manufacturing. However, the terminology used in this disclosure assumes that when the component is mounted onto a circuit board, the bottom surface of the component faces said circuit board, while the top surface faces away from said circuit board (i.e. the top surface is further away from said circuit board than the bottom surface).

The upper unit 26 of the housing delimits the top 291 of the enclosure 29 in figure 2a. In other words, the upper unit 26 forms the ceiling of the enclosure. The MEMS chip 21 may be mounted directly on this ceiling, or it may be mounted to an additional mounting surface which has been attached to the ceiling. In either case, the MEMS chip 21 is mounted on the top 291 of the enclosure 29. This may be called an "upside-down position", if we label the side of the chip which is intended to be attached to a mounting surface the "downside", and the opposite side the "upside". It may then be noted that the chip-centered terms "upside" / "downside" do not follow the component-centered terminology described in the previous paragraph.

The upper unit 26 may form an external top surface of the housing. The upper unit 26 comprise a ceramic package structure which may form at least the top surface of the enclosure 29. The MEMS chip 21 may be mounted directly onto the ceramic package structure. Alternatively, the component may comprise a separate mounting surface (not illustrated) which is attached to the ceramic package structure on the top 291 of the enclosure 29. The MEMS chip 21 may be mounted on this mounting surface.

The electrical connections 231 and 232 may be formed in the ceramic package structure when it is manufactured. They may for example be made of wolfram. The external contact electrode 25 may be formed in the lower unit 24, as figures 2a - 2b illustrate. The external contact electrode 25 may be coated for example with a Ni / Au alloy to facilitate soldering. In any embodiment in this disclosure, the ceramic package structure can be made of aluminium oxide, beryllium oxide or aluminium nitride.

Figure 2a illustrates an embodiment where the sidewalls 27 are an integral part of the upper unit 26 of the housing and a ceramic floor structure forms the lower unit 24 of the housing. The bottom of the ceramic floor structure thereby forms the external bottom surface 241 of the housing. The electrical connection 232 in which extends through the upper unit 26 and through the sidewall 27 can for example be soldered to the corresponding electrical connection 242 in the lower unit 24 when the upper and lower units are attached to each other. This establishes electrical contact between the MEMS chip 21 and the contact electrode 25 on the external bottom surface.

More generally, a ceramic floor structure may form at least a part of the lower unit of the housing. The lower unit may have a more complex structure than figure 2a illustrates. Some parts of the lower unit may for example be made of ceramic materials and other parts of non-ceramic materials, such as plastics or metals. The ceramic material of the ceramic floor structure may be any of the material options listed above for the ceramic package structure. As mentioned earlier, the ceramic floor structure may form the part of the lower unit 24 where the external bottom surface 241 is located. The external contact electrode 25 may be attached to the ceramic floor structure.

The ceramic floor structure may also form the part of the lower unit 24 which delimits the bottom of the enclosure 29. In other words, the ceramic floor structure may form the bottom surface inside the enclosure 29. This is illustrated in figures 2a and 2b.

Figure 2b illustrates an alternative where the MEMS component comprises a control chip 22 inside the enclosure 20, and the control chip is 22 mounted to the bottom 292 of the enclosure 29. The electrical connections 23, 231, 232 and 242 connect the MEMS chip 21 to the control chip 22 and to the contact electrode 25. An additional contact electrode 251, which could be used for transferring an additional electrical signal between the chips and the printed circuit board, is also illustrated in figure 2b on the external bottom surface 241 of the housing. The control chip 22 is typically not as sensitive to mechanical stress as the MEMS chip, so the performance of the MEMS component may be the same regardless of which side of the enclosure the control chip 22 is placed on. Electrical connections which extend directly across the enclosure 29 may connect MEMS chip 21 to control chip 22. This option has not been illustrated.

Figure 3a illustrates a MEMS component where reference numbers 30, 31, 32, 34, 35, 36, 37, 38, 39, 332 and 391 correspond to reference numbers 20, 21, 22, 24, 25, 26, 27, 28, 29, 232 and 291, respectively, in figures 2a - 2b. Here the lower unit 34 comprises a metallic or plastic floor structure 34 which is attached to the upper unit 36 or to the sidewalls 37 and delimits the bottom of the enclosure 39. The upper unit 36 may for example comprise a support structure 361 which is a part of the ceramic package structure and is formed around the edges of the enclosure 39. The floor structure 341 may be attached to the support structure 361. This encapsulation can be made hermetic. If the floor structure 341 is metallic, then it may be attached to the ceramic support structure 361 by soldering. If the floor structure 341 is plastic, then it may be attached with glue.

The sidewalls 37 extend in figure 3a below the lower unit 34 and they form the external bottom surface 341 where the contact electrode 35 is located. Other arrangements are also possible. The control chip 22 may be mounted on the floor structure 34 if it is made of an insulating material. Electrical connections which extend directly across the enclosure 29 may in that case connect MEMS chip 21 to control chip 22. This option has not been illustrated.

All preceding figures 2a - 3a have illustrated devices where a contact electrode (25, 35) is located on the external bottom surface (241, 341) of the component. In other words, in these preceding embodiments electrical connections (232, 242, 332) are internal connections which extend through the ceramic package structure in the upper housing unit 36 and through the sidewall 37 to the external bottom surface (241, 341).

Figure 3b illustrates an alternative configuration where the electrical connections 333 extend through the ceramic package structure which forms the upper unit 36. But no electrical connections extend through the sidewalls 37. Instead, the MEMS component comprises electrical connections 334 which extend to the contacting side 30 of the component 3 on the outer surface of the sidewalls 37. Electrical connections 334 may for example be castellations. Connections 333 and 334 are connected to each other.

Figure 3c illustrates an alternative configuration where the electrical connections 335 extend through the ceramic package structure which forms the upper unit 36. The MEMS component here comprises electrical connections 336 which extend to the contacting side 30 of the component 3 outside of the sidewalls 37. Electrical connections 336 may for example be metallic wires. Connections 336 and 337 are coupled to each other, as figure 3b illustrates.

The contacting embodiments illustrated in figures 3a - 3c can be combined with any other embodiment presented above.

## Claims

1. A MEMS component which comprises a MEMS chip and a housing which forms an enclosure around the MEMS chip, wherein the enclosure has a top and a bottom and the housing has an upper unit, a lower unit and sidewalls which extend between the upper unit and the lower unit, and the upper unit of the housing delimits the top of the enclosure, and the lower unit of the housing delimits the bottom of the enclosure,
and the lower unit or the sidewalls of the housing form an external bottom surface of the housing, and the external bottom surface lies on a contacting side of the component, and
the housing comprises a ceramic package structure, and the MEMS component comprises electrical connections which extend from the MEMS chip through the ceramic package structure to the contacting side of the component,
**characterized in that** the ceramic package structure forms at least the upper unit of the housing and the MEMS chip is mounted to the top of the enclosure.

2. A MEMS component according to claim 1, wherein a ceramic floor structure forms at least a part of the lower unit of the housing.

3. A MEMS component according to claim 2, wherein the ceramic floor structure forms the external bottom surface.

4. A MEMS component according to any of claims 2-3, wherein the ceramic floor structure forms the part of the lower unit which delimits the bottom of the enclosure.

5. A MEMS component according to claim 4, wherein the MEMS component comprises a control chip inside the enclosure, and the control chip is mounted to the bottom of the enclosure.

6. A MEMS component according to any of claim 1, wherein the lower unit comprises a metallic or plastic floor structure which delimits the bottom of the enclosure.

7. A MEMS component according to any preceding claim, wherein the component is a gyroscope.

8. A MEMS component according to any of claims 1-7, wherein the component is an accelerometer.
